# EUROPEAN PATENT SPECIFICATION

(11) **EP 1 422 750 B1**
(45) Date of publication and mention of the grant of the patent: **28.07.2010**
(21) Application number: 03730872.3
(22) Date of filing: 10.06.2003
(51) Int. Cl.: H01L 21/78, B23K 26/04

(54) **METHOD AND APPARATUS FOR SPLITTING SEMICONDUCOR WAFER**
VERFAHREN UND VORRICHTUNG ZUM SPLITTEN EINES HALBLEITER-WAFERS
PROCEDE ET DISPOSITIF SERVANT A DIVISER UNE TRANCHE DE SEMI-CONDUCTEUR

(30) Priority: 19.06.2002 JP 2002178182
(43) Date of publication of application: 26.05.2004
(73) Proprietor: Disco Corporation, Tokyo 143-8580 (JP)
(72) Inventor: NAGAI, Yusuke, Ota-ku, Tokyo 144-8650 (JP)
(74) Representative: Müller-Boré & Partner Patentanwälte
(86) International application number: PCT/JP2003/007326
(87) International publication number: WO 2004/001827

(56) References cited:
- WO-A-02/22301
- JP-A- 7 075 955
- JP-A- 9 323 300
- JP-A- 10 332 332
- JP-A- 53 114 347
- JP-A- 55 053 437

## Description

### TECHNICAL FIELD

The present invention relates to a method of dividing a semiconductor wafer into individual semiconductor chips by exposing the semiconductor wafer to a laser beam along predetermined streets (cutting lines) according to the preamble of claim 1, and to a dividing apparatus according to the preamble of claim 2.

### BACKGROUND ART

Document JP 53 114 347 A discloses a method according to the preamble of claim 1 and a dividing apparatus wherein a semiconductor wafer is placed on a XY table in such a manner that circuits formed on its top surface face down. An infrared laser beam is irradiated onto the surface of the semiconductor wafer from the back side thereof through a condenser lens to form grooves along streets arranged on the front surface in a lattice pattern.

Document JP 07 075 955 A discloses a precision cutting device with an alignment unit mounted thereon to perform alignment between a blade and a cut area of a workpiece. An infrared camera capable of recognizing infrared rays is included by the alignment unit. The alignment unit further includes a lighting system, a microscope and a narrow-band filter for passing only infrared rays of a specific wavelength.

Document JP 10 332 332 A discloses an area detecting method, wherein an image pickup means includes a storage means for storing the focal point position of a semiconductor wafer by coordinates on a Z-axis, and has a function of automatically matching a focal point with the stored focal point position. Light including infrared rays is radiated on the wafer, and the focal point of an image pickup element is matched with the stored focal point position, and the circuit surface having a target is displayed on a monitor.

Document JP 09 323 300 A discloses a substrate dividing method, wherein a groove is formed in the surface of a substrate, putting a photoabsorber provided with an optical characteristic to absorb a specified wavelength of light into a bottom part of this groove, and then a laser beam is irradiated and it is absorbed in the photoabsorber on the bottom part of the groove, through which the substrate is divided along the groove by volumetric heat expansion of the photoabsorber and the vicinity of the bottom part of that time.

Document JP 55 053 437 A discloses a semiconductor wafer dividing method and its apparatus. The semiconductor is mounted on a wafer substrate with its element-formed surface directed downward. The back surface of the wafer is thus exposed upward and observed by means of an infrared microscope. Based on observed patterns and by using a diamond, a scratch is made on the back surface; and applying pressure on the wafer, it is separated into individual elements.

Document WO 02/22301 discloses a dividing apparatus according to the preamble of claim 2 capable of cutting a workpiece without producing a fusing and a cracking out of a predetermined cutting line on the surface of the workpiece. A laser beam is irradiated on the predetermined cut line on the surface of the workpiece under the conditions of causing a multiple photon absorption and with a condensed point aligned to the inside of the workpiece, and a modified area is formed inside the workpiece along the predetermined cut line by moving the condensed point along the predetermined cut line, whereby the workpiece can be cut with a rather small force by cracking the workpiece along the predetermined cut line.

As is known to people of ordinary skill in the art, in the production of a semiconductor device, a plurality of areas are defined by streets (cutting lines) formed on the front surface of a substantially disk-shaped semiconductor wafer in a lattice form, and a circuit such as IC or LSI is formed in each of the defined areas. The semiconductor wafer is cut along the streets to separate the areas having circuit formed therein from one another, thereby manufacturing individual semiconductor chips. Cutting along the streets of the semiconductor wafer is generally carried out by a cutting machine called "dicer". This cutting machine has a chuck table for holding a semiconductor wafer as a workpiece, a cutting means for cutting the semiconductor wafer held on the chuck table, and a moving means for moving the chuck table and the cutting means relative to each other. The cutting means comprises a rotary spindle that is rotated at a high speed and a cutting blade mounted to the spindle. The cutting blade comprises a disk-shaped base and an annular cutting edge that is mounted to the outer peripheral portion of the side wall of the base, and the cutting edge is so formed to have a thickness of about 15 µm by fixing diamond abrasive grains having a diameter of, for example, about 3 µm to the base by electroforming. When a semiconductor wafer having a thickness of 50 µm or less is cut by using such cutting blade, the cut surface of the cut semiconductor chip has flaws or cracks, thereby causing deterioration in quality of the semiconductor chip.

To form a finer IC or LSI circuit pattern, a semiconductor wafer such as a silicon wafer having the front surface of a low-dielectric insulating material laminated thereon has recently been put to practical use. Examples of the low-dielectric insulating material include materials having a dielectric constant (for example, k = about 2.5 to 3.6) lower than an SiO₂ film (dielectric constant k = about 4.1), such as films of an inorganic material, e.g., SiOF, BSG(SiOB) or H-containing polysiloxane (HSQ), films of an organic material such as a polyimide-based, parylene-based or Teflon-based polymer, and porous silica films such as a methyl-containing polysiloxane. When such semiconductor wafers are cut with the above cutting blade, the surface layer, that is, the low-dielectric insulating layer is peeled off from the semiconductor wafer body by a breaking force of the cutting blade even in an area adjacent to a street due to the high fragility of the low-dielectric insulating material, thereby deteriorating the quality of divided semiconductor chips.

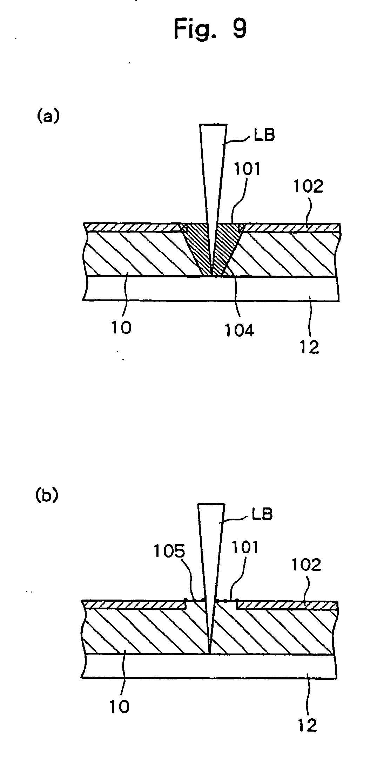

Meanwhile, as shown in Figs. 9, attempts have been made to cut the semiconductor wafer 10 by irradiating it with a laser beam LB along the streets 101 of the semiconductor wafer 10. This method for cutting by irradiation of a laser beam is a method to cut the semiconductor wafer 10 by melting the street 101 thereof with the laser beam LB. Accordingly, a problem can be solved with that the low-dielectric insulating layer is separated from the semiconductor wafer body.

However, in the method in which the laser beam LB is irradiated along the streets 101 of the semiconductor wafer 10, the semiconductor wafer 10 is heated to a fairly high temperature by the laser beam LB, as shown in Fig. 9(a). As shown in Fig. 9(a), this area 104 to be affected by heat is large on the front surface side of the semiconductor wafer 10 and gradually decreases toward the rear surface side. Therefore, there is a problem that circuits 102 formed on the front surface of the semiconductor wafer 10 may be damaged by the influence of heat. Further, since the method in which the semiconductor wafer 10 is irradiated along the streets 101 with the laser beam LB is to cut the semiconductor wafer 10 by melting the streets 101 of the semiconductor wafer 10 with the laser beam LB, a new problem arises that debris 105 is produced as shown in Fig. 9(b) and adheres to a bonding pad connected to the circuits 102, thereby deteriorating the quality of the semiconductor chips.

The present invention has been made in view of the above fact, and its principal technical subject is to provide a method of dividing a semiconductor wafer by using a laser beam, which enables the semiconductor wafer to be divided along streets without damaging circuits formed on the front surface of the semiconductor wafer by the influence of heat and without allowing debris to adhere to a bonding pad or the like; as well as a dividing apparatus.

This object is fulfilled by the method being the features of claim 1 and the apparatus having the features disclosed in claim 2.

With the specific processing conditions such as pulse width of about 1 to 500 pico seconds, a wavelength of about 200 to 600 nm and a repetition frequency of about 1 to 100 kHz, unnecessary heating to the semiconductor or the workpiece is reduced. If, for example, the pulse width is too large, the semiconductor wafer exposed to the laser beam tends to be heated at a considerably high temperature and molten.

### BRIEF DESCRIPTION OF THE DRAWINGS

Fig. 1 is a perspective view of a dividing apparatus constituted according to the present invention;
Fig. 2 is a perspective view showing the main constituent elements of the dividing apparatus shown in Fig. 1;
Fig. 3 is a block diagram schematically showing the constitution of laser beam processing means provided in the dividing apparatus shown in Fig. 1;
Fig. 4 is a sectional view showing that a semiconductor wafer to be divided by the dividing apparatus shown in Fig. 1 is placed on a protective tape affixed to a frame;
Fig. 5 is a constitution diagram of an alignment means provided in the dividing apparatus shown in Fig. 1;
Figs. 6 are diagrams for explaining the dividing method of the present invention;
Fig. 7 is a graph showing the transmittances of the materials of semiconductor wafers;
Figs. 8 are diagrams showing states cut by the dividing method of the present invention; and
Figs. 9 are diagrams showing states cut by the laser beam cutting of the prior art.

### BEST MODE FOR CARRYING OUT THE INVENTION

The method of dividing a semiconductor wafer and the dividing apparatus constituted according to preferred embodiments of the present invention will be described in detail with reference to the accompanying drawings.

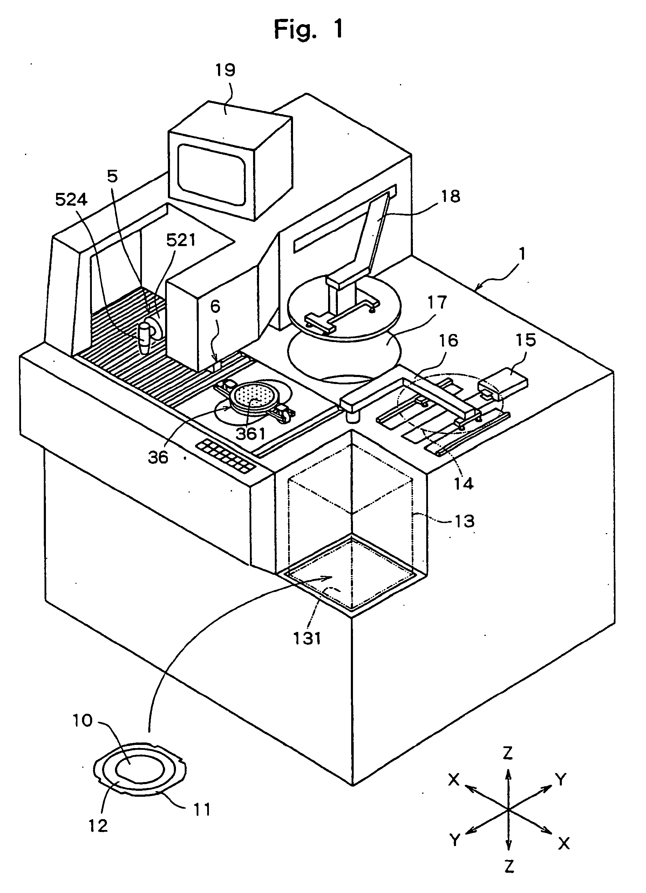

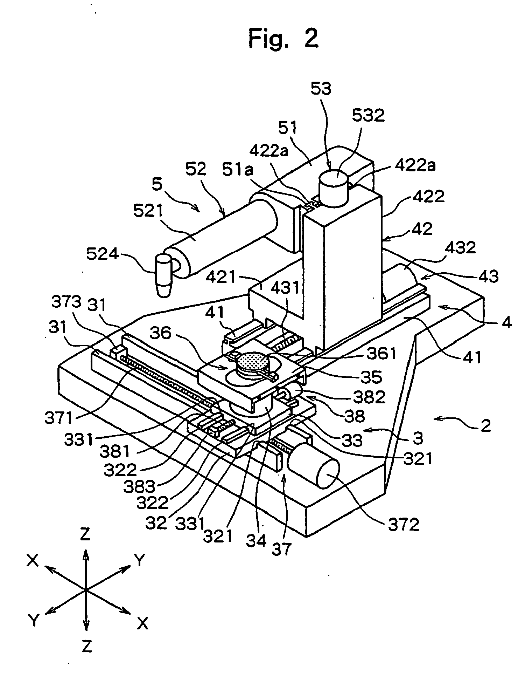

Fig. 1 is a perspective view of the dividing apparatus for a semiconductor wafer constituted according to the present invention. The dividing apparatus shown in Fig. 1 comprises a substantially rectangular parallelepiped housing 1. Within this housing 1, there are installed a stationary base 2 shown in Fig. 2, a chuck table mechanism 3 for holding a workpiece, which is mounted on the stationary base 2 in such a manner that it can move in a direction shown by an arrow X, a laser beam unit support mechanism 4 mounted on the stationary base 2 in such a manner that it can move in a direction shown by an arrow Y perpendicular to the direction shown by the arrow X, and a laser beam unit 5 mounted on the laser beam unit support mechanism 4 in such a manner that it can move in a direction shown by an arrow Z.

The above chuck table mechanism 3 comprises a pair of guide rails 31, 31 disposed on the stationary base 2 and arranged parallel to each other in the direction shown by the arrow X, a first sliding block 32 disposed on the guide rails 31, 31 in such a manner that it can move in the direction shown by the arrow X, a second sliding block 33 disposed on the first sliding block 32 in such a manner that it can move in the direction shown by the arrow Y, a support table 35 supported on the second sliding block 33 by a cylindrical member 34, and a chuck table 36 as a workpiece holding means. This chuck table 36 has an adsorption chuck 361 made of a porous material so that a disk-shaped semiconductor wafer as a workpiece is held on the adsorption chuck 361 by a suction means that is not shown. The chuck table 36 is turned by a pulse motor (not shown) installed in the cylindrical member 34.

The above first sliding block 32 has, on its under surface, a pair of to-be-guided grooves 321, 321 to be fitted to the above pair of guide rails 31 and 31 and has, on its top surface, a pair of guide rails 322, 322 formed parallel to each other in the direction shown by the arrow Y. The first sliding block 32 constituted as described above can move in the direction shown by the arrow X along the pair of guide rails 31, 31 by fitting the to-be-guided grooves 321, 321 to the pair of guide rails 31, 31. The chuck table mechanism 3 in the illustrated embodiment is provided with a first moving means 37 for moving the first sliding block 32 along the pair of guide rails 31, 31 in the direction shown by the arrow X. The first moving means 37 comprises a male screw rod 371 disposed between the above pair of guide rails 31, 31 and in parallel thereto and a drive source such as a pulse motor 372 or the like for rotationally driving the male screw rod 371. The male screw rod 371 is, at its one end, rotatably supported to a bearing block 373 fixed to the above stationary base 2 and is, at the other end, transmission-coupled to the output shaft of the above pulse motor 372 by a speed reducer that is not shown. The male screw rod 371 is screwed into an internally threaded through-hole formed in a female screw block (not shown) provided projectingly on the under surface of the center portion of the first sliding block 32. Therefore, by driving the male screw rod 371 in normal or in reverse by the pulse motor 372, the first sliding block 32 is moved along the guide rails 31, 31 in the direction shown by the arrow X.

The above second sliding block 33 has, on its under surface, a pair of to-be-guided grooves 331, 331 to be fitted to the pair of guide rails 322 and 322 provided on the top surface of the above first sliding block 32 and can be moved in the direction shown by the arrow Y by fitting the to-be-guided grooves 331, 331 to the pair of guide rails 322, 322. The chuck table mechanism 3 in the illustrated embodiment is provided with a second moving means 38 for moving the second sliding block 33 in the direction shown by the arrow Y along the pair of guide rails 322, 322 provided on the first sliding block 32. The second moving means 38 comprises a male screw rod 381 disposed between the above pair of guide rails 322 and 322 and in parallel thereto and a drive source such as a pulse motor 382 or the like for rotationally driving the male screw rod 381. The male screw rod 381 is, at its one end, rotatably supported to a bearing block 383 fixed on the top surface of the above first sliding block 32 and is, at its other end, transmission-coupled to the output shaft of the above pulse motor 382 by a speed reducer that is not shown. The male screw rod 381 is screwed into an internally threaded through-hole formed in a female screw block (not shown) provided projectingly to the under surface of the center portion of the second sliding block 33. Therefore, by driving the male screw rod 381 in normal or in reverse by the pulse motor 382, the second sliding block 33 is moved along the guide rails 322, 322 in the direction shown by the arrow Y.

The above laser beam unit support mechanism 4 has a pair of guide rails 41, 41 mounted on the stationary base 2 and arranged parallel to each other in the index feeding direction shown by the arrow Y and a movable support base 42 disposed on the guide rails 41 and 41 in such a manner that it can move in the direction shown by the arrow Y. This movable support base 42 comprises a movable support portion 421 movably disposed on the guide rails 41, 41 and a mounting portion 422 mounted on the movable support portion 421. The mounting portion 422 is provided, on one side surface, with a pair of guide rails 422a, 422a in parallel to each other extending in the direction shown by the arrow Z. The laser beam support mechanism 4 in the illustrated embodiment has a third moving means 43 for moving the movable support base 42 along the pair of guide rails 41, 41 in the direction shown by the arrow Y, which is an index feeding direction. The third drive means 43 comprises a male screw rod 431 disposed between the above pair of guide rails 41, 41 and in parallel thereto and a drive source such as a pulse motor 432 or the like for rotationally driving the male screw rod 431. The male screw rod 431 is, at its one end, rotatably supported to a bearing block (not shown) fixed to the above stationary base 2 and is, at its other end, transmission-coupled to the output shaft of the above pulse motor 432 by a speed reducer that is not shown. The male screw rod 431 is screwed into an internally threaded through-hole formed in a female screw block (not shown) provided projectingly to the under surface of the center portion of the movable support portion 421 constituting the movable support base 42. Therefore, by driving the male screw rod 431 in normal or in reverse by the pulse motor 432, the movable support base 42 is moved along the guide rails 41, 41 in the index feeding direction shown by the arrow Y.

The laser beam unit 5 in the illustrated embodiment comprises a unit holder 51 and a laser beam processing means 52 secured to the unit holder 51. The unit holder 51 is provided with a pair of to-be-guided grooves 51a, 51a to be slidably fitted to the pair of guide rails 422a, 422a provided on the above mounting portion 422, and is supported in such a manner that it can be moved in the direction shown by the arrow Z by fitting the to-be-guided grooves 51a, 51a to the above guide rails 422a and 422a. The laser beam unit 5 in the illustrated embodiment comprises a fourth moving means 53 for moving the unit holder 51 along the pair of guide rails 422a, 422a in the direction shown by the arrow Z. The fourth moving means 53 comprises a male screw rod (not shown) arranged between the pair of guide rails 422a, 422a and a drive source such as a pulse motor 532 or the like for rotationally driving the male screw rod, like the first to third moving means. By driving the male screw rod (not shown) by the pulse motor 532 in normal or in reverse, the unit holder 51 and the laser beam processing means 52 are moved along the guide rails 422a, 422a in the direction shown by the arrow Z.

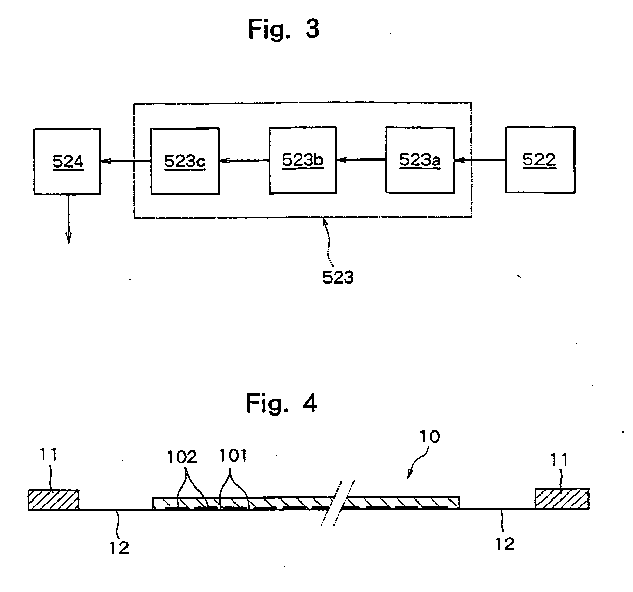

A description is subsequently given of the above laser beam processing means 52 with reference to Fig. 2 and Fig. 3.

The illustrated laser beam processing means 52 comprises a cylindrical casing 521 secured to the above unit holder 51 and extending substantially horizontally. In the casing 521, there are installed a laser beam oscillation means 522 and a laser beam modulation means 523 as shown in Fig. 3. A YAG laser oscillator or YVO4 laser oscillator may be used as the laser beam oscillation means 522. The laser beam modulation means 523 comprises a repetition frequency setting means 523a, a laser beam pulse width setting means 523b and a laser beam wavelength setting means 523c. The repetition frequency setting means 523a, laser beam pulse width setting means 523b and laser beam wavelength setting means 523c constituting the laser beam modulation means 523 may be of forms well known among people skilled in the art and therefore, detailed descriptions of their structures are omitted in this text. A laser beam irradiation means 524 that may be of a well known form per se is attached to the top end of the above casing 521.

A laser beam oscillated from the above laser beam oscillation means 522 reaches the laser beam irradiation means 524 through the laser beam modulation means 523. The repetition frequency setting means 523a in the laser beam modulation means 523 changes the laser beam to a laser beam having a predetermined repetition frequency, the laser beam pulse width setting means 523b sets the pulse width of the pulse laser beam to a predetermined width, and the laser beam wavelength setting means 523c sets the wavelength of the pulse laser beam to a predetermined value. According to experiments conducted by the inventors of the present invention, the pulse width of the pulse laser beam is 1 to 500 ps (picosecond). When the pulse width is too large, the semiconductor wafer exposed to the laser beam tends to be heated at a considerably high temperature and molten. The repetition frequency is desirably about 1 to 100 KHz. The wavelength of the pulse laser beam is about 200 to 600 nm.

Returning to Fig. 1, the illustrated dividing apparatus comprises a cassette 13 for storing the semiconductor wafer 10 that is a workpiece. This cassette 13 is placed on a cassette table 131 which can be moved vertically by a lifting means that is not shown. The semiconductor wafer 10 is secured on an annular frame 11 by a protective tape 12 and stored in the above cassette 13 in a state of being mounted on the frame 11. The front surface, that is, a surface on which streets 101 and circuits 102 are formed, of the semiconductor wafer 10 is adhered to the protective tape 12, as shown in Fig. 4. The illustrated dividing apparatus comprises a workpiece carrying-out/carrying-in mechanism 15 for carrying out the semiconductor wafer 10 stored in the cassette 13 to a workpiece placing area 14 and carrying the processed semiconductor wafer 10 into the cassette 13, a workpiece conveying mechanism 16 for conveying the semiconductor wafer 10 carried out to the workpiece placing area 14 to the above chuck table 36, a cleaning means 17 for cleaning the semiconductor wafer 10 divided on the chuck table 36 and a cleaning/conveying means 18 for conveying the semiconductor wafer 10 divided on the chuck table 36 to the cleaning means 17. The illustrated dividing apparatus further comprises an alignment means 6, which is composed of a microscope or an image pickup device for picking up an image of a street or the like formed on the semiconductor wafer 10 held on the chuck table 36 and a display means 19 for displaying an image picked up by the alignment means 6.

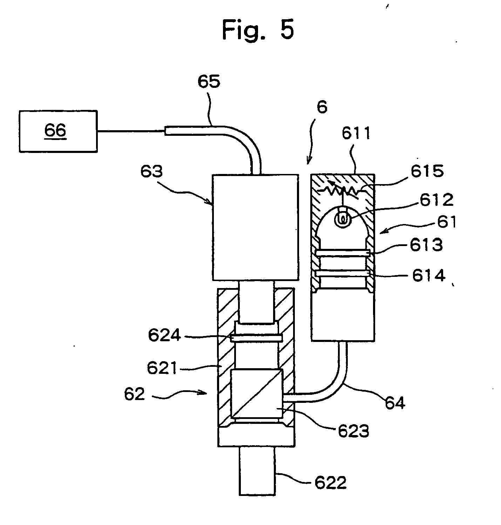

A description is subsequently given of the above alignment means 6 with reference to Fig. 5.

The illustrated alignment means 6 is constituted by an illuminator 61, a microscope 62, an infrared image pickup device 63 and a control means 66. The illuminator 61 comprises a case 611, an illuminant 612 such as a halogen lamp or the like arranged in the case 61, a heat ray absorption filter 613 arranged below the illuminant 612 and an infrared-transparent narrow-band-pass filter 614 arranged below the heat ray absorption filter 613. The illuminant 612 of the thus constituted illuminator 61 is connected to a power source (not shown) via a dimmer 615 to apply infrared radiation through the infrared-transparent narrow-band-pass filter 614.

The above microscope 62 comprises a case 621, an optical system including an objective lens 622 attached to the lower end of the case 621 and a half mirror 623 arranged in the case 621, and an infrared-transparent narrow-band-pass filter 624 arranged above the half mirror 623. The half mirror 623 and the above infrared-transparent narrow-band-pass filter 614 are connected to each other by a glass fiber 64. The infrared image pickup device 63 is attached to the thus constituted microscope 62 in such a manner that their optic axes are aligned with each other. The infrared image pickup device 63 sends an electric signal corresponding to infrared radiation received through the above infrared-transparent narrow-band-pass filter 624. This electric signal output from this infrared image pickup device 63 is sent to the control means 66 that is composed of a microcomputer, via a cable 65, and the control means 66 carries out control processing such as image processing or the like based on the input electric signal and displays its processing result on the display means 19.

The constitution of the above infrared-transparent narrow-band-pass filters 614 and 624 may be either one of them. The glass fiber 64 for connecting the illuminator 61 with the half mirror 623 of the microscope 62 is not always necessary. In this case, infrared radiation may be directly applied to the illuminator 61 and the half mirror 623 of the microscope 62. Further, the illuminator 61 may be so constituted to be separated from the microscope 62 as to illuminate the workpiece directly.

The dividing apparatus in the illustrated embodiment is constituted as described above, and description will be made mainly of its dividing operation hereinbelow.

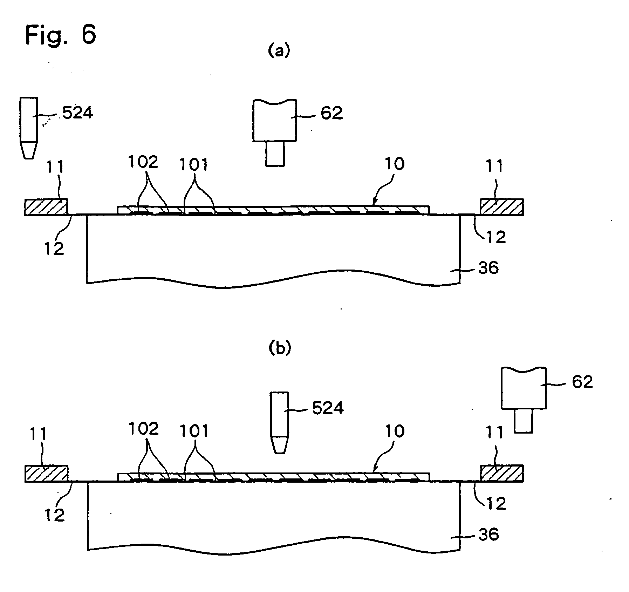

The front surface, that is, a surface, on which street 101 and circuit 102 are formed, of the semiconductor wafer 10 is adhered to the protective tape 12 affixed to the annular frame 11, as described above (see Fig. 4). The semiconductor wafer 10 supported on the annular frame 11 via the protective tape 12 (to be simply referred to as "semiconductor wafer 10" hereinafter) is stored at a predetermined position of the cassette 13 in such a manner that the back surface, that is, a surface, on which the streets 101 and the circuits 102 are not formed, of the semiconductor wafer 10 faces up. The semiconductor wafer 10 stored at the predetermined position of the cassette 13 is brought to a carrying-out position by the vertical movement of the cassette table 131 by a lifting means that is mot shown. Then, the semiconductor wafer 10 brought to the carrying-out position is carried to the workpiece placing area 14 by the advance or retreat movement of the workpiece carrying-out means 15. The semiconductor wafer 10 carried to the workpiece placing area 14 is conveyed to the top surface of the adsorption chuck 361 of the chuck table 36 constituting the above chuck table mechanism 3 by turning motion of the workpiece conveyor means 16, and suction-held on the adsorption chuck 361. The chuck table 36 thus suction-holding the semiconductor wafer 10 is moved along the guide rails 31, 31 by the operation of the first moving means 37 to position right below the alignment means 6 as shown in Fig. 6(a).

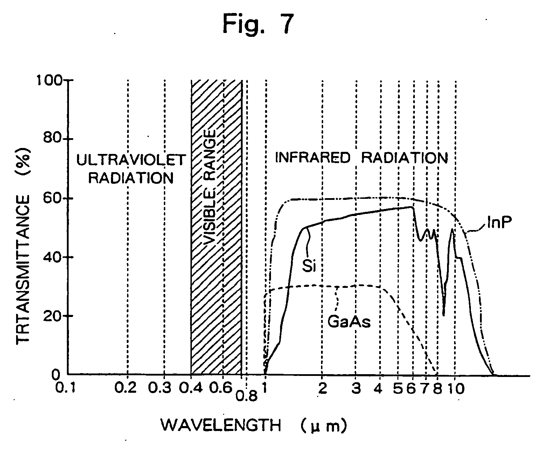

When the chuck table 36 is positioned right below the alignment means 6 as described above, image processing such as pattern matching is carried out by the alignment means 6 and control means (not shown) in order to align the laser beam irradiation means 524 of the laser beam unit 5 for illuminating a laser beam along a street with the street formed on the semiconductor wafer 10, whereby the alignment of a laser beam irradiation position is performed. In this alignment, infrared radiation irradiated from the illuminator 61 is applied through the microscope 62 to the semiconductor wafer 10 held on the chuck table 36 in a state of its back surface facing up. Here, the wavelength of infrared radiation applied to the semiconductor wafer 10 is studied. Fig. 7 is a graph showing the light transmittances of crystals of silicon (Si), gallium arsenide (GaAs) and indium (InP) used as materials for the semiconductor wafer, and in Fig. 7, the horizontal axis indicates the wavelength of light and the longitudinal axis indicates transmittance of light. As understood from Fig. 7, all of the above materials have a high transmittance at an infrared wavelength range of 1 to 10 µm. Therefore, the narrow-band-pass filter 614 of the illuminator 61 and the narrow-band-pass filter 624 of the microscope 62 constituting the above alignment means 6 may be a narrow-band-pass filter for transmitting only infrared radiation having a wavelength of 1 to 10 µm.

Infrared radiation applied to the back surface of the semiconductor wafer 10 reaches up to the interior of the semiconductor wafer 10 and is reflected on the surfaces of circuits such as IC's and LSI's formed on the front surface of the semiconductor wafer 10 affixed to the protective tape 12. An image formed by this reflected infrared radiation is captured by the optical system composed of the object lens 622 and the half mirror 623, the infrared radiation captured by the optical system is converted into an electric signal by the image pickup device 63, and the electric signal so formed is sent to the control means 66. The control means 66 carries out image processing such as pattern matching etc. , based on the electric signal from the image pickup device 63, displays the processed image on the display means 19 and detects a street formed on the semiconductor wafer 10 (street detection step) to align it with the laser beam irradiation means 524 of the laser beam unit 5 for irradiating a laser beam.

When the street formed on the semiconductor wafer 10 held on the chuck table 36 in such a manner that its back surface faces up has been detected and the alignment of the laser beam irradiation position has been conducted, as described above, the chuck table 36 is moved to a cutting area where the laser beam irradiation means 524 of the laser beam unit 5 is located, as shown in Fig. 6(b), and the laser beam irradiation means 524 irradiates a laser beam along the detected street from the back surface of the semiconductor wafer 10 in the cutting area as described above to cut the semiconductor wafer 10 along the street (cutting step).

The cutting step will be described hereinbelow.

In the cutting step, the chuck table 36, i.e., the semiconductor wafer 10 held on the chuck table 36 is moved in the direction shown by the arrow X at a predetermined feed speed while the laser beam is illuminated toward the back surface of a predetermined street of the semiconductor wafer 10 from the laser beam irradiation means 524. On this occasion, as for processing conditions in the case where the thickness of the semiconductor wafer 10 made of silicon (Si) is about 50 µm, it is desirable that a YAG laser having a wavelength of 355 nm, a repetition frequency of 20 KHz and an output of 3 W is used and the feed speed is about 100 mm/sec.

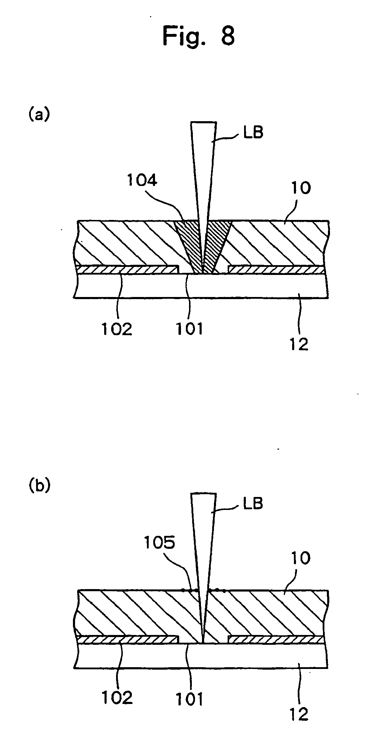

Fig. 8(a) shows a heat affected area 104 when a laser beam is applied to the detected street 101 from the back surface of the semiconductor wafer 10 as described above. As understood from this heat affected area 104, since the heat affected area on the back surface side devoid of the circuits 102 is large and gradually decreases toward the front surface on which the circuit 102 is formed, the influence of heat on the circuits 102 formed on the front surface of the semiconductor wafer 10 is small and the damage of the circuits 102 by heat can be prevented. Although debris 105 is produced by applying a laser beam LB to the semiconductor wafer 10 as shown in Fig. 8(b), it adheres onto the back surface devoid of the circuits 102 and not to a bonding pad or the like.

After the cutting step is carried out along the predetermined street as described above, the chuck table 36 and the semiconductor wafer 10 held on the chuck table 36 are moved by a distance between adjacent streets in the direction shown by the arrow Y (indexing step) and then, the above cutting step is carried out similarly. After the cutting step and the indexing step are made on all the streets extending in the predetermined direction, the chuck table 36, i.e., the semiconductor wafer 10 held on the chuck table 36 is turned at 90° to carry out the above cutting step and indexing step along streets extending in a direction perpendicular to the above predetermined direction, thereby dividing the semiconductor wafer 10 into individual semiconductor chips. After the semiconductor wafer 10 has been divided into individual semiconductor chips, the chuck table 36 holding the semiconductor wafer 10 is returned to the position where it first suction-holds the semiconductor wafer 10 and the suction-holding of the semiconductor wafer 10 is canceled there. Thereafter, the semiconductor wafer 10 is conveyed to the cleaning means 17 by the cleaning/conveyor means 18 and is cleaned there. The thus cleaned semiconductor wafer 10 is carried to the workpiece placing area 14 by the workpiece conveying means 16. Then, the semiconductor wafer 10 is stored at a predetermined position of the cassette 13 by the workpiece carrying-out means 15.

In the above-described illustrated embodiment, to carry out the cutting step, the semiconductor wafer 10 held on the chuck table 36 is moved. However, the laser beam irradiation means 524 may be moved instead. Further, although in the illustrated embodiment, the semiconductor wafer 10 held on the chuck table 36 is moved in the indexing direction shown by the arrow Y, there may be employed a constitution that the laser beam irradiation means 524 is moved in the indexing direction shown by the arrow Y. In this case, however, when the laser beam irradiation means 524 is moved, there is a possibility that accuracy is deteriorated by vibration or the like. Therefore, it is preferred that the laser application means 524 be brought to rest and the chuck table 36, i.e., the semiconductor wafer 10 held on the chuck table 36 be properly moved.

### Industrial Feasibility

According to the semiconductor wafer dividing method and dividing apparatus of the present invention, a street is detected from the back surface of the semiconductor wafer, a laser beam is applied to the detected street from the back surface of the semiconductor wafer to cut it along the street, thereby making it possible to reduce the influence of heat on circuits formed on the front surface of the semiconductor wafer and to prevent the damage of the circuits by heat. Although debris is produced by exposing the semiconductor wafer to a laser beam, it adheres to the back surface devoid of the circuits and not to a bonding pad or the like.

## Claims

1. Method of dividing a semiconductor wafer (10) having circuits (102) formed in a plurality of areas defined by streets (101) arranged on the front surface in a lattice form along the streets (101), comprising:
a step of detecting the streets (101) from the back surface of the semiconductor wafer (10) by irradiating the back surface with radiation and detecting the streets (101) from an image formed by the radiation; and
a step of cutting the semiconductor wafer (10) along the streets (101) detected in the street detection step by applying a laser beam to the back surface of the semiconductor wafer (10), along the street (101),
**characterized in, that**
the radiation by which the back surface is irradiated is infrared radiation and that said laser beam has a pulse width of about 1 to 500 pico seconds, a wavelength of about 200 to 600 nm, and a repetition frequency of about 1 to 100 kHz.

2. Dividing apparatus for dividing a semiconductor wafer (10) having circuits (102) formed in a plurality of areas defined by streets (101) arranged on the front surface in a lattice form along the streets (101), held on a chuck table (36), said dividing apparatus comprising:
an alignment means (6) for detecting an area to be divided from a semiconductor wafer (10) held on the chuck table (36), said alignment means (6) including an infrared radiation illuminating means (61) for applying infrared radiation to the semiconductor wafer (10), an optical system(622, 623, 624) for capturing infrared radiation reflected on the surfaces of circuits formed on the front surface of the semiconductor wafer (10), an image pickup device (63) for outputting an electric signal corresponding to infrared radiation captured by the optical system (622, 623, 624), and a control means (66) for processing an image based on the output signal from the image pickup device (63);
a laser beam oscillating means from which a laser beam is oscillated and
a laser beam irradiation means (524) for applying a laser beam to the area to be divided, which has been detected by the alignment means (6);
**characterized in, that**
the dividing apparatus includes a laser beam modulation means (523) with a repetition frequency setting means (523a), a laser beam pulse width setting means (523b), and a laser beam wavelength setting means (523c), said laser beam reaching said laser beam irradiation means (524) through said laser beam modulation means (523) set for said laser beam to have a pulse width of about 1 to 500 pico seconds, and a wavelength of about 200 to 600 nm, and to change said laser beam to have a repetition frequency of about 1 to 100 kHz.

## Patentansprüche

1. Verfahren zum Teilen eines Halbleiter-Wafers (10), der in einer Vielzahl von durch Straßen (101) definierten Bereichen Schaltungen (102) ausgebildet hat, die auf der vorderen Oberfläche in einer Gitterform entlang der Straßen (101) ausgebildet sind, das umfasst:
einen Schritt zum Erfassen der Straßen (101) von der hinteren Oberfläche des Halbleiter-Wafers (10) durch Bestrahlen der hinteren Oberfläche mit Strahlung und Erfassen der Straßen (101) aus einem Bild, das durch die Strahlung ausgebildet wird; und
einen Schritt zum Schneiden des Halbleiter-Wafers (10) entlang der Straßen (101), die in dem Straßenerfassungsschritt erfasst werden, durch Anwenden eines Laserstrahls auf die hintere Oberfläche des Halbleiter-Wafers (10) entlang der Straße (10),
**dadurch gekennzeichnet, dass**
die Bestrahlung, mit der die hintere Oberfläche bestrahlt wird, Infrarotstrahlung ist und dass der Laserstrahl eine Impulsbreite von etwa 1 bis 500 Pikosekunden, eine Wellenlänge von etwa 200 bis 600 nm und eine Wiederholfrequenz von etwa 1 bis 100 kHz hat.

2. Teilungsvorrichtung zum Teilen eines Halbleiter-Wafers (10), der in einer Vielzahl von durch Straßen (101) definierten Bereichen Schaltungen (102) ausgebildet hat, die auf der vorderen Oberfläche in einer Gitterform entlang der Straßen (101) ausgebildet sind, der auf einem Aufspanntisch (36) gehalten wird, wobei die Teilungsvorrichtung umfasst:
ein Ausrichtungsmittel (6) zum Erfassen eines Bereichs, der von einem auf einem Aufspanntisch (36) gehaltenen Halbleiter-Wafer (10) getrennt werden soll, wobei das Ausrichtungsmittel (6) umfasst: ein Infrarotbestrahlungsmittel (61) zum Anwenden von Infrarotstrahlung auf den Halbleiter-Wafer (10), ein optisches System (622, 623, 624) zum Einfangen von Infrarotstrahlung, die auf den Oberflächen von Schaltungen reflektiert wird, die auf der vorderen Oberfläche des Halbleiter-Wafers (10) ausgebildet sind, eine Bildaufnahmevorrichtung (63) zum Ausgeben eines elektrischen. Signals, das der von dem optischen System (622, 623, 624) eingefangenen Infrarotstrahlung entspricht, und ein Steuermittel (66) zum Verarbeiten eines Bilds basierend auf dem Ausgangssignal von der Bildaufnahmevorrichtung (63);
ein Laserstrahlschwingungsmittel, von dem der Laserstrahl in Schwingungen versetzt wird, und
ein Laserstrahlabstrahlungsmittel (524) zum Anwenden eines Laserstrahls auf den Bereich, der geteilt werden soll, der von dem Ausrichtungsmittel (6) erfasst wurde;
**dadurch gekennzeichnet, dass**
die Teilungsvorrichtung umfasst: ein Laserstrahlmodulationsmittel (523) mit einem Wiederholungsfrequenzfestlegungsmittel (523a), einem Laserstrahlimpulsbreitenfestlegungsmittel (523b) und einem Laserstrahlwellenlängenfestlegungsmittel (523c), wobei der Laserstrahl das Laserstrahlbestrahlungsmittel (524) durch das Laserstrahlmodulationsmittel (523) erreicht, das derart festgelegt ist, dass der Laserstrahl eine Impulsbreite von etwa 1 bis 500 Pikosekunden und eine Wellenlänge von etwa 200 bis 600 nm hat und es eine Wiederholfrequenz des Laserstrahls auf etwa 1 bis 100 kHz ändert.

## Revendications

1. Procédé servant à diviser une tranche de semi-conducteur (10) présentant des circuits (102) formés dans une pluralité de zones définies par des rues (101) placées sur la surface avant sous forme de treillis le long des rues (101), comprenant :
une étape consistant à détecter les rues (101) depuis la surface arrière de la tranche de semi-conducteur (10) en irradiant la surface arrière avec un rayonnement et détecter les rues (101) à partir d'une image formée par le rayonnement : et
une étape consistant à couper la tranche de semi-conducteur (10) le long des rues (101) détectées dans l'étape de détection des rues en appliquant un faisceau laser sur la surface arrière de la tranche de semi-conducteur (10), le long de la rue (101), **caractérisé en ce que** le rayonnement par lequel la surface arrière est irradiée est un rayonnement infrarouge et **en ce que** ledit faisceau laser présente une largeur d'impulsion d'environ 1 à 500 picosecondes, une longueur d'onde d'environ 200 à 600 nm, et une fréquence de répétition d'environ 1 à 100 kHz.

2. Dispositif de division servant à diviser une tranche de semi-conducteur (10) présentant des circuits (102) formés dans une pluralité de zones définies par des rues (101) placées sur la surface avant sous forme de treillis le long des rues (101), retenue sur une table de serrage (36), ledit dispositif de division comprenant :
un moyen d'alignement (6) pour détecter une zone à diviser d'une tranche de semi-conducteur (10) retenue sur une table de serrage (36), ledit moyen d'alignement (6) comprenant un moyen d'éclairage à rayonnement infrarouge (61) pour appliquer un rayonnement infrarouge à la tranche de semi-conducteur (10), un système optique (622, 623, 624) pour saisir un rayonnement infrarouge réfléchi sur les surfaces de circuits formés sur la surface avant de la tranche de semi-conducteur (10), un dispositif de capture d'images (63) pour émettre un signal électrique correspondant au rayonnement infrarouge saisi par le système optique (622, 623, 624), et un moyen de commande (66) pour traiter une image basée sur le signal de sortie du dispositif de capture d'images (63) ;
un moyen d'oscillation de faisceau laser par lequel un faisceau laser est oscillé et
un moyen d'irradiation à faisceau laser (524) pour appliquer un faisceau laser sur la zone à diviser, qui a été détectée par le moyen d'alignement (6) ;
**caractérisé en ce que**
le dispositif de division comprend un moyen de modulation de faisceau laser (523) avec un moyen de réglage de fréquence de répétition (523a), un moyen de réglage de largeur d'impulsion de faisceau laser (523b), et un moyen de réglage de longueur d'onde de faisceau laser (523c), ledit faisceau laser atteignant ledit moyen d'irradiation à faisceau laser (524) à travers le ledit moyen de modulation de faisceau laser (523) réglé pour que le faisceau laser ait une largeur d'impulsion d'environ 1 à 500 picosecondes, et une longueur d'onde d'environ 200 à 600 nm, et pour changer ledit faisceau laser pour qu'il ait une fréquence de répétition d'environ 1 à 100 kHz.
